# EUROPEAN PATENT APPLICATION

(11) **EP 1 837 945 A1**
(43) Date of publication of application: **26.09.2007**
(21) Application number: 07075186.2
(22) Date of filing: 13.03.2007
(51) Int. Cl.: H01P 1/203

(54) **Method for creating and tuning electromagnetic bandgap structure and device**

(30) Priority: 21.03.2006 US 385271
(71) Applicant: Delphi Technologies, Inc., Troy, Michigan 48007 (US)
(72) Inventor: Berlin, Carl W., West Lafayette, IN 47906 (US); Nair, Deepukumar M., Kokomo, IN 46902 (US); Walsh, Matthew R., Sharpsville, IN 46068 (US)
(74) Representative: Denton, Michael John

(57) **Abstract**

Tuned Electromagnetic Bandgap (EBG)devices (10, 30), and a method for making and tuning tuned EBG devices (10, 30) are provided. The method includes the steps of providing first and second overlapping substrates (32, 32a), placing magnetically alignable conductive material (36) between the substrates (32, 32a), and applying a magnetic field (44, 45) in the vicinity of the magnetically alignable conductive material (36) to align at least some of the material into conductive vias (46, 47). The method further includes the steps of physically altering via characteristics of EBG devices (10, 30) to tune the bandpass and resonant frequencies of the EBG devices (10, 30).

## Description

### Technical Field

The present invention generally relates to Electromagnetic Bandgap (EBG) devices, and more particularly, to the creation and tuning of EBG devices to alter the device's bandgap or resonant characteristics.

### Background of the Invention

EBG devices are devices generally having an ability to suppress and filter electromagnetic energy. EBG devices are often used to help suppress switching noise and electromagnetic radiation in printed circuit boards (PCBs) and packages containing electronic devices. Such devices are also sometimes used to improve the performance of planar antennas by reducing cross-coupling between antenna array elements through surface waves, and by suppressing and directing radiation. EBG devices can be useful in other active and passive devices and applications such as oscillators, waveguides, transmission lines, amplifiers, filters, power combining circuits, phased arrays, mixers, and microwave components and devices.

A typical EBG device generally has a periodic structure, such as for example, a lattice, that is made up of periodic perturbations. These periodic perturbations, also known as vias, can take the form of holes or dielectric or metal rods or posts. Often an EBG device takes the form of a uniform substrate material with metal on both sides creating a parallel plate. The substrate between the parallel plates is typically loaded with metal or dielectric rods or patches that form the periodic perturbations.

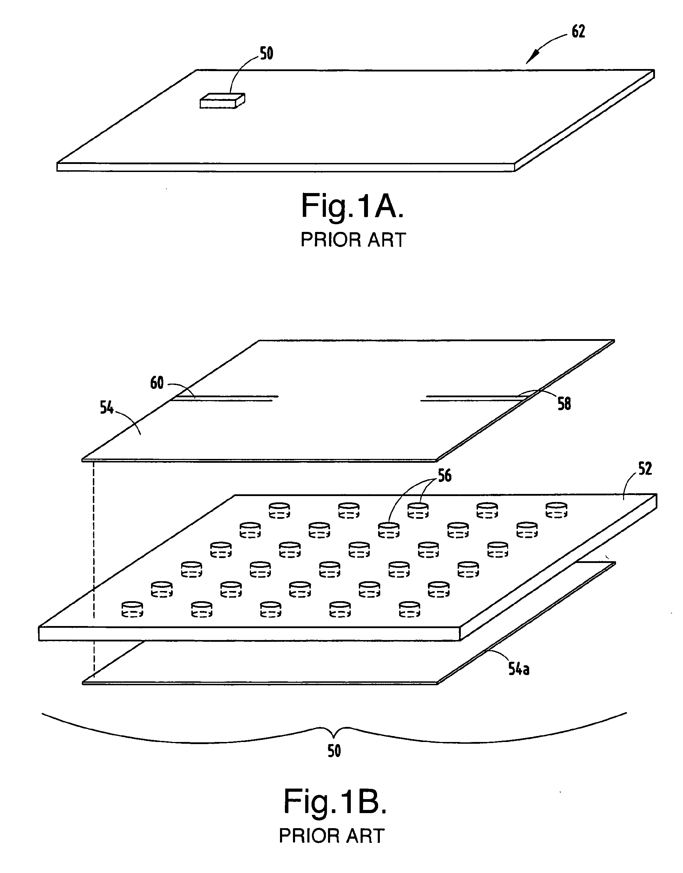

Fig. 1A provides an example of a conventional EBG device 50 located in a printed circuit board (PCB) 62. Fig. 1B provides an enlarged view of the EBG device 50. As shown, EBG device 50 has a dielectric layer 52 positioned between two ground planes 54 and 54a. Embedded in dielectric layer 52 are conductive vias 56 in a regular periodic pattern. Conductive vias 56 are typically formed from metal or a metal alloy. EBG device 50 is also shown having a coplanar waveguide input 58, and a coplanar waveguide output 60. In operation, the periodic pattern of conductive vias 56 acts to filter the coplanar waveguide input 58 before the signal is output at the coplanar waveguide output 60.

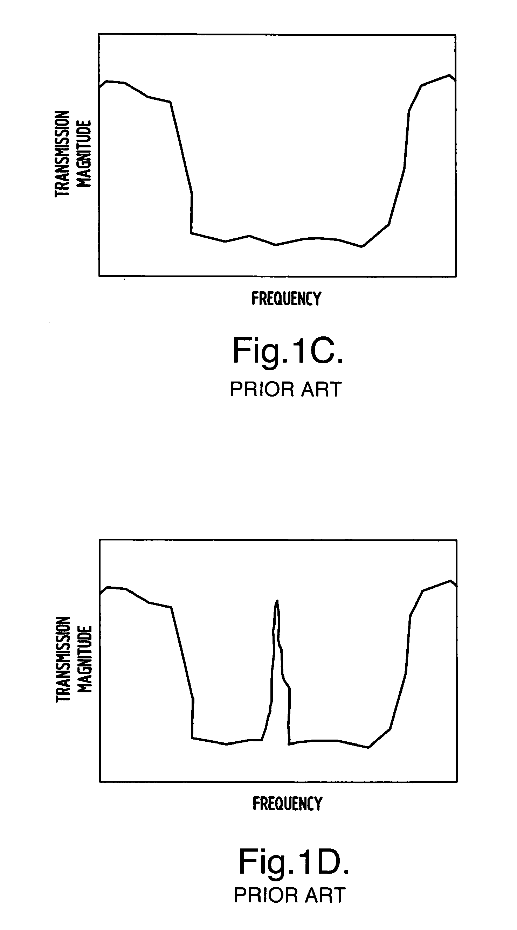

A typical EBG device 50 functions to block or suppress the propagation of electromagnetic radiation that falls within a certain defined frequency band known as a stopband or bandgap. The EBG device 50 can be characterized by its stopband/bandgap characteristics. These can include the width of the stopband/bandgap and the location in the frequency spectrum of the stopband/bandgap. For a given EBG device 50, the characteristics of the stopband/bandgap are generally determined by the physical characteristics and location of the periodic perturbations or conductive vias 56 in the device. The overall effect of the conductive vias 56 in an EBG device 50 is to create a filter that blocks electromagnetic energy in a certain frequency range from propagating in the substrate and on the surface of the substrate. Characteristics of the perturbations, or conductive vias 56, that can determine the bandgap characteristics include the spacing of the perturbations, the size of the perturbations, and the material used to create the perturbations. By choosing certain materials, sizes, and locations, the width and frequency location of the bandgap can be selected. Fig. 1C generally illustrates the transmission characteristics associated with the conventional EBG device 50. As can be seen, the conventional EBG device 50 will typically pass certain frequency ranges (those above and below the bandgap), and will attenuate frequencies that fall within the bandgap.

Conventional EBG devices discussed above can also be formed to allow some frequencies of electromagnetic energy within the bandgap to propagate. This is commonly accomplished by including defects, called defect resonators, in the EBG structure when it is manufactured. These defect resonators are interruptions or defects in the symmetry of the otherwise regular pattern of periodic perturbations 56 in the EBG device 50. For example, in an EBG device 50 including a periodic pattern of perturbations that are conductive vias 56, a defect could be formed by not including one of the conductive vias in the periodic pattern when the EBG device is manufactured. In another example involving a single substrate plane with a periodic pattern of via apertures filled with a dielectric material, a defect could be formed by not filling one of the via apertures.

In operation, a defect resonator in an EBG device 50 typically creates an area of resonance in the EBG device 50 by localizing energy within the structure, allowing transmission of a narrow frequency within the stopband or bandgap of the EBG device 50. In effect, an EBG device 50 formed with a defect resonator typically acts as a high-Q filter, suppressing frequencies within the bandgap except for those resonated by defects. Fig. 1D provides a general illustration of the frequency characteristics of the conventional EBG device 50 having a defect resonator. As can be seen, an EBG device 50 having a defect resonator will typically allow some frequencies within the bandgap to pass through the EBG device without being significantly attenuated.

Although characteristics of EBG devices with and without defect resonators can be selected prior to the manufacturing of the structures, manufacturing process imprecision and changed requirements can make it difficult to manufacture EBG devices that precisely meet desired bandgap and resonance characteristics. It is therefore desirable to provide for a bandgap device that is tunable, and a method for effectively tuning such devices.

### Summary of the Invention

In accordance with one aspect of the present invention, a method for making a magnetically tuned Electromagnetic Bandgap (EBG) device is provided. The method includes the steps of providing two overlapping parallel planar substrates, placing magnetically alignable conductive material between the substrates, and placing a ground plane between each dielectric planar surface and the magnetically alignable conductive material. The method also includes the steps of placing a patterned mask with magnetically permeable openings adjacent to one of the substrates, applying a magnetic field to the mask, causing at least some of the magnetically alignable conductive material to align into conductive columns (vias), and applying heat to the magnetically alignable conductive material so that the conductive vias remain after removal of the magnetic field.

According to another aspect of the present invention, another method for making a magnetically tuned EBG device is provided. The method includes the steps of positioning a dielectric layer between two ground planes. The dielectric layer has a regular pattern of via holes, one of which is not filled with a material. The method also includes the step of at least partially filling the empty hole with magnetically alignable conductive material. The method further includes the steps of applying a magnetic field to the via hole filled with the magnetically alignable conductive material, causing some of the magnetically alignable conductive material to align into a conductive column (via). Finally, the method includes the step of applying heat to the magnetically alignable conductive material so that the conductive via remains after removal of the magnetic field.

In accordance with a further aspect of the present invention, a magnetically-tuned EBG device is provided. The device includes magnetically alignable conductive material that has been formed into a regular pattern of conductive vias by means of a magnetic field, and that is located between two overlapping parallel planar substrates. The device also includes a ground plane located between each planar substrate and the magnetically alignable conductive material.

In accordance with another aspect of the present invention, a magnetically tuned EBG device is provided. The device includes at least one planar substrate located between two ground planes, and having a pattern of regular via holes extending into the planar substrate from the surface. At least one of the via holes is at least partially filled with magnetically alignable conductive material that has been aligned into a conductive via.

In accordance with still another aspect of the present invention, a method for creating a defect in an EBG device is provided. The method includes the steps of providing an EBG device having a regular pattern of filled via holes in a planar substrate that is located between two ground planes, and altering the geometry or location of at least one of the filled via holes to create a defect in the regular pattern of filled via holes.

In accordance with yet a further aspect of the present invention, a method for tuning a defect in an EBG device is provided. The method includes the steps of providing an EBG device having at least one defect resonator located within the structure, and altering the geometry or location of the defect resonator.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Fig. 1A is a perspective view illustrating a conventional Electromagnetic Bandgap device on a circuit board substrate;
Fig. 1B is an enlarged exploded view of the conventional Electromagnetic Bandgap device;
Fig. 1C is a waveform diagram illustrating a bandgap associated with the Electromagnetic Bandgap device shown in Fig. 1B;
Fig. 1D is a waveform diagram illustrating a bandgap and resonant frequency associated with an Electromagnetic Bandgap device of Fig. 1B having a defect resonator;
Fig. 2 is a perspective view illustrating a structure used in a method for making an Electromagnetic Bandgap device, according to a first embodiment of the present invention;
Fig. 3 is a perspective view illustrating the step of applying a magnetic field to the structure of Fig. 2, according to the method;
Fig. 4 is a perspective view illustrating a completed Electromagnetic Bandgap device created using the method;
Fig. 5 is a cross-sectional view taken through line V-V of Fig. 4 further illustrating the Electromagnetic Bandgap device created using the method;
Fig. 6A is a perspective exploded view illustrating a structure used in a method for making an Electromagnetic Bandgap device, according to a second embodiment of the present invention;
Fig. 6B is a cross-sectional view taken through line VIB-VIB of Fig. 6A;
Fig. 6C is a perspective view illustrating the step of applying a magnetic field to the structure of Fig. 6 in the method, according to the second embodiment;
Fig. 6D is a perspective view illustrating a completed Electromagnetic Bandgap device created using the method, according to the second embodiment;
Fig. 7 is a cross-sectional view taken through line VII-VII of Fig. 6D further illustrating the Electromagnetic Bandgap device;
Fig. 8A is a perspective view of a structure used in a method for tuning an Electromagnetic Bandgap device, according to a third embodiment of the present invention;
Fig. 8B is a cross-sectional view taken through line VIIIB-VIIIB of Fig. 8A;
Fig. 8C is a waveform diagram illustrating transmission and frequency characteristics of an Electromagnetic Bandgap tuned using the method, according to the third embodiment;
Fig. 9A is a top down view illustrating an Electromagnetic Bandgap device before it has been tuned, according to the third embodiment;
Fig. 9B is a top down view of an Electromagnetic Bandgap device after it has been tuned by the method, according to the third embodiment;
Fig. 9C is a waveform diagram illustrating the transmission and frequency characteristics of an Electromagnetic Bandgap device before it has been tuned;
Fig. 9D is a waveform diagram illustrating the transmission and frequency characteristics of an Electromagnetic Bandgap device that has been tuned by the method, according to the third embodiment;
Fig. 10A is a top down view of an Electromagnetic Bandgap device having a defect resonator before it has been tuned by the method, according to a fourth embodiment of the present invention;
Fig. 10B is a top down view illustrating an Electromagnetic Bandgap device after a defect resonator has been removed by the method, according to the fourth embodiment;
Fig. 10C is a waveform diagram illustrating the transmission and frequency characteristics of an Electromagnetic Bandgap device having a defect resonator; and
Fig. 10D is a waveform diagram illustrating the transmission and frequency characteristics of an Electromagnetic Bandgap device that has had a defect resonator removed by the method, according to the fourth embodiment.

### Description of the Preferred Embodiments

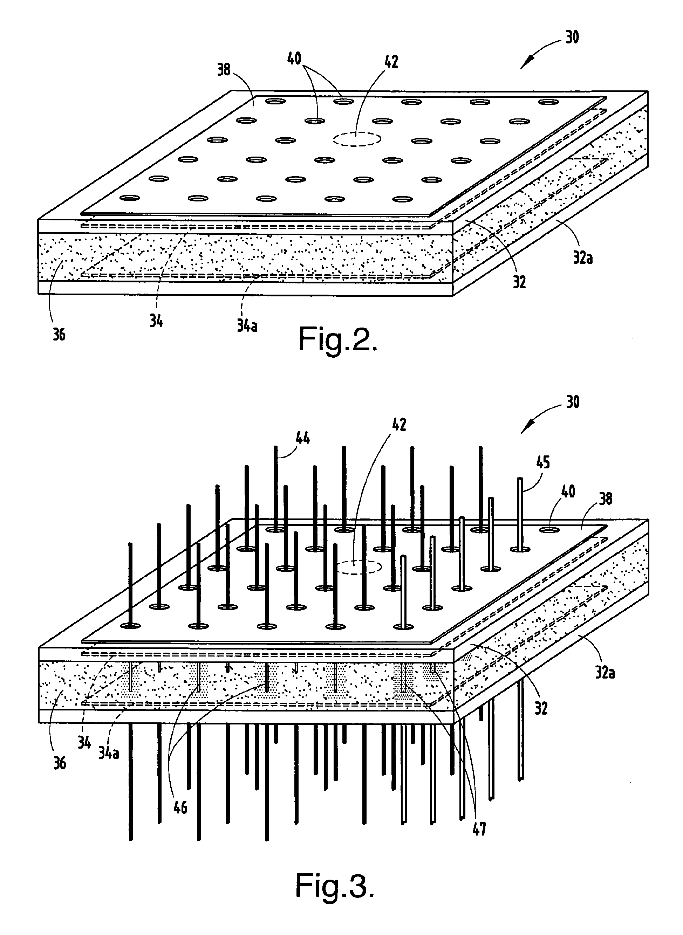

Referring to Figs. 2-5, a method for making a magnetically tuned Electromagnetic Bandgap (EBG) device is generally illustrated according to a first embodiment of the present invention. Referring to Fig. 2, first and second planar substrates 32 and 32a made of a dielectric material are provided, according to a first step of the method. The first and second planar substrates 32 and 32a are printed circuit boards (PCBs), according to one embodiment. Alternatively, first and second planar substrates 32 and 32a can be a high-frequency substrate, such as low-temperature co-fired ceramic (LTCC). First and second planar substrates 32 and 32a are located such that they substantially overlap, and are parallel to, each other, and such that there is a gap between the adjacent inner surfaces of the first and second planar substrates 32 and 32a.

In the second step of the method, first and second ground planes 34 and 34a are placed between first and second substrates 32 and 32a, such that the first ground plane 34 is located adjacent to the inner surface of the first planar substrates 32, and such that the second ground plane 34a is located adjacent to the inner surface of the second planar substrate 32a. Ground planes 34 and 34a are electrically conductive and, in one embodiment, are made of copper. Alternatively, ground planes 34 and 34a could be made of other metals, metal alloys or other electrically conducting materials.

In a third step of the method, magnetically alignable conductive material 36 is disposed between the first and second inner surfaces of planar substrates 32 and 32a, and between first and second ground planes 34 and 34a. According to one exemplary embodiment, the magnetically alignable conductive material 36 is a conductive epoxy sold by Nexaura Systems LLC. Alternatively, magnetically alignable conductive material 36 could be another epoxy containing magnetically alignable conductive matter, or another material containing magnetically alignable conductive matter.

The device formed in the above steps is a layered structure 30 with a first planar substrate layer 32a, a first ground plane 34a located on top of an inner surface of the first substrate layer 32a, magnetically alignable conductive material 36 disposed on top of the inner surface of the first substrate layer 32a and the first ground plane 34a, a second ground plane 34 located on top of the magnetically alignable conductive material 36, and a second planar substrate 32 located on top of the second ground plane 34 and the magnetically alignable conductive material 36.

In the next step of the method, a patterned mask 38 is placed adjacent and parallel to the outer surface of planar substrate 32. Alternatively, patterned mask 38 could be placed adjacent and parallel to the outer surface of planar substrate 32a, or adjacent and parallel to the inner surface of planar substrate 32 or 32a. Patterned mask 38 could alternatively be located between and parallel to planar substrates 32 and 32a. Patterned mask 38 may be made of a MuMetal alloy material that is generally impervious to magnetic fields, according to one embodiment. Alternatively, patterned mask 38 could be made of other materials capable of masking a magnetic field. Patterned mask 38 includes a number of magnetically permeable mask openings 40. Magnetically permeable mask openings 40 are located in patterned mask 38 such that they form a regular, periodic lattice of magnetically permeable openings. As shown in Fig. 2, the regular pattern of magnetically permeable mask openings 40 in patterned mask 38 is interrupted by a mask opening defect 42. Mask opening defect 42 is an area in patterned mask 38 that would normally contain a magnetically permeable mask opening 40 corresponding to the regular lattice pattern of the other magnetically permeable mask openings in patterned mask 38, but does not. Instead, mask opening defect 42 is less magnetically permeable than magnetically permeable mask openings 40.

Referring to Fig. 3, a magnetic field (illustrated by flux lines 44 and 45) is shown applied to the structure 30 in a further step of the method. As shown, the magnetic field includes areas of stronger magnetic field 45 and weaker magnetic field 44. The magnetic field 44 and 45 passes through patterned mask 38 and into magnetically alignable conductive material 36 at locations having magnetically permeable mask openings 40. As shown, little or no magnetic field 44 and 45 passes through patterned mask 38 into magnetically alignable conductive material 36 in areas where there are no magnetically permeable mask openings 40. As shown, magnetically alignable conductive material 36 that is located beneath magnetically permeable mask openings 40 forms into conductive columns or vias 46 and 47 due to the alignment of the magnetically alignable matter in the magnetically alignable conductive material 36 in response to the applied magnetic field. In areas where the magnetic field is stronger, such as areas near magnetic field 45, the resulting magnetically aligned columns 47 have higher conductivity. In areas of magnetically alignable conductive material 36 subject to a weaker magnetic field 44, the conductivity of the resulting magnetically aligned columns 46 is lower. In areas where little or no magnetic field penetrates magnetically permeable mask 38, such as areas beneath mask opening defect 42, the magnetically alignable conductive material 36 does not form into conductive columns or vias.

In the next step of the method, heat is applied to the structure 30 at a sufficient temperature and duration to cure the magnetically alignable conductive material 36, such that the conductive vias 46 and 47 remain in place after the magnetic field 44 and 45 has been removed. Although as shown, the magnetically alignable conductive material 36 is cured by a heating process, it should be appreciated that magnetically alignable conductive material 36 that is curable by means other than heat could be used. Such material could be cured, for example, by a chemical curing process or by ultraviolet light. After the magnetically alignable conductive material 36 has been cured by heating so that the conductive vias 46 and 47 remain in place, the magnetic field 44 and 45 may be removed.

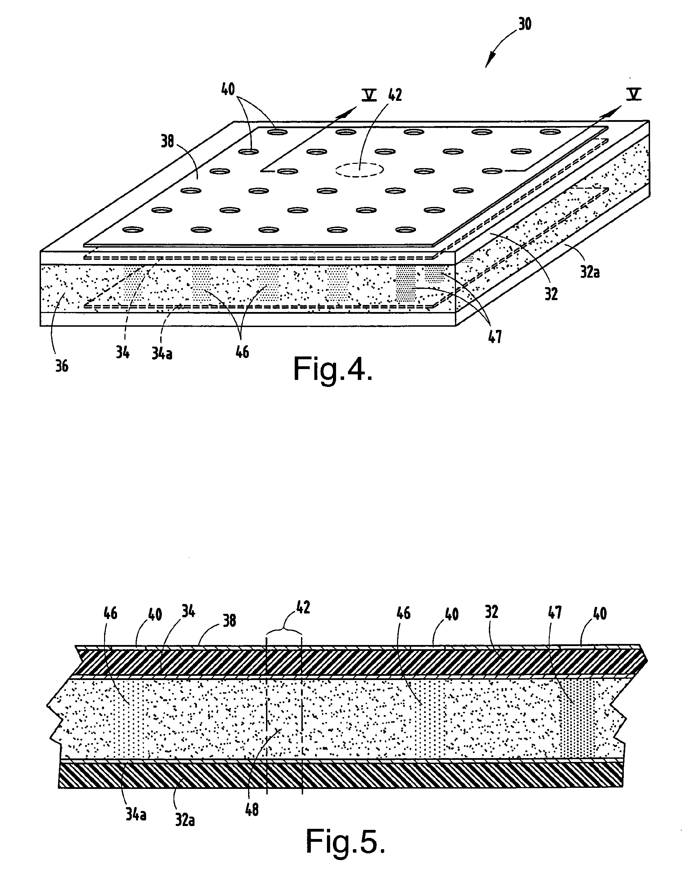

In Fig. 4, the resulting EBG device 30 after the steps of the method have been completed is illustrated. As seen, the EBG device 30 contains a regular pattern of conductive vias 46 and 47 located beneath magnetically permeable mask openings 40 of patterned mask 38. Conductive vias 46 and 47 are located between, and generally perpendicular to, the inner surfaces of planar substrates 32 and 32a and between the inner surfaces of ground planes 34 and 34a. Conductive vias 47, located in an area of the structure exposed to a higher magnetic field 45, have a higher conductivity than conductive vias 46, located in an area exposed to a weaker magnetic field 44. As shown in Fig. 4, conductive vias are not formed beneath areas of the mask lacking magnetically permeable mask openings 40. More specifically, a conductive via has not been formed beneath the location of mask opening defect 42.

Fig. 5 further shows a conductive via 47, and conductive vias 46, located beneath magnetically permeable mask openings 40. The conductivity of conductive via 47 is higher than the conductivity of the conductive vias 46 due to the fact that the magnetically alignable conductive material 36, from which conductive via 47 was formed, was in an area of higher magnetic field than the magnetically alignable conductive material 36 forming conductive vias 46.

Fig. 5 also shows defect area 48 located beneath mask opening defect 42. Defect area 48 is an area that would normally have been a conductive via 46 or 47, but is not. This is due to the fact that mask opening defect 42 prevented a magnetic field from entering magnetically alignable conductive material 36 with sufficient strength to align the magnetically alignable particles in magnetically alignable conductive material 36 into a conductive column or via. The result is a defect in the regular pattern of conductive vias 46 and 47 in EBG device 30. This defect in the regular pattern of conductive vias is known as a defect resonator.

The resulting EBG device 30 shown in Figs. 4 and 5 is an EBG device having a defect resonator. It should be appreciated that an EBG device without a defect resonator could be formed by the method by providing a patterned mask 38 without a mask opening defect 42. In addition, it should be appreciated that an EBG device having multiple defect resonators could be provided by utilizing a patterned mask 38 having multiple mask opening defects 42. It should also be appreciated that patterned mask 38 could be a permanent part of EBG device 30, or that patterned mask 38 could be removed at some point in the process after the conductive vias 46 and 47 have been formed and cured to fix them in place.

Although the method described a magnetic field with areas of stronger and weaker magnetic flux, it should be appreciated that a uniform magnetic field could be utilized, resulting in a lattice of conductive vias having essentially the same conductivity. Finally, it should be appreciated that the planar substrates or ground planes used in the method could include a coplanar waveguide.

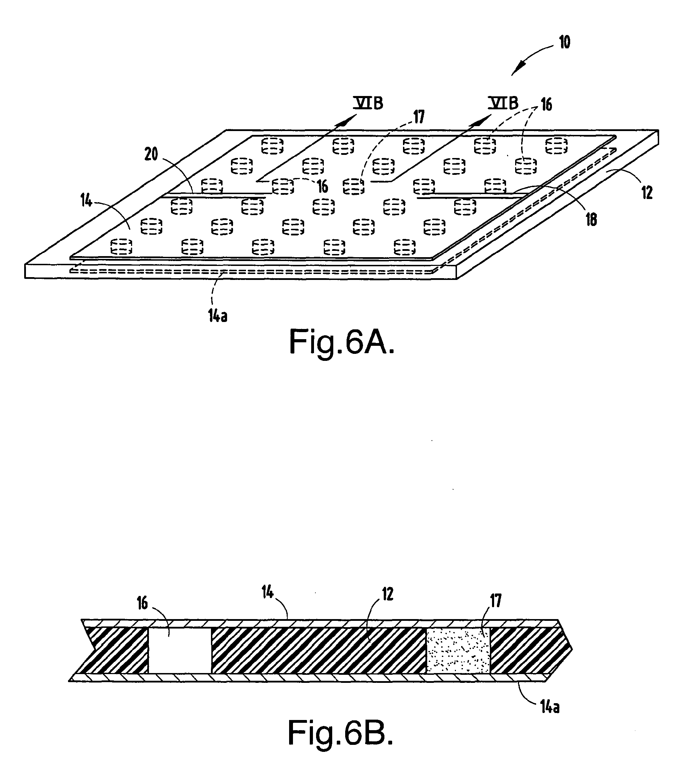

Referring to Figs. 6A-7, a method for forming a magnetically tuned EBG device 10 having a defect resonator is generally illustrated, according to a second embodiment of the present invention. In Figs. 6A-6B, a planar substrate 12 made of a dielectric material is provided according to a first step of the method. Planar substrate 12 is a printed circuit board, according to one embodiment. Alternatively, planar substrate 12 can be a high-frequency substrate, such as low-temperature co-fired ceramic (LTCC). Planar substrate 12 is shown having a periodic lattice of via holes 16 extending into planar substrate 12 from the surface of planar substrate 12. Planar substrate 12 is also shown having a coplanar waveguide formed in the substrate, including a coplanar waveguide input 18, and a coplanar waveguide output 20.

In the second step of the method, according to the second embodiment, a magnetically alignable conductive material 17 is disposed in one of the via holes 16 to fill or at least partially fill the via hole 16. The magnetically alignable conductive material 17 is a conductive epoxy sold by Nexaura Systems LLC, according to one embodiment. Alternatively, magnetically alignable conductive material 17 could be a different epoxy containing magnetically alignable conductive matter. The via holes 16 not filled with magnetically alignable conductive material 17 can remain unfilled, or can be filled with a material, such as a metal, metal alloy, or dielectric. Next, ground planes 14 and 14a are positioned above and below, respectively, the planar substrate 12, in a position adjacent to substrate 12.

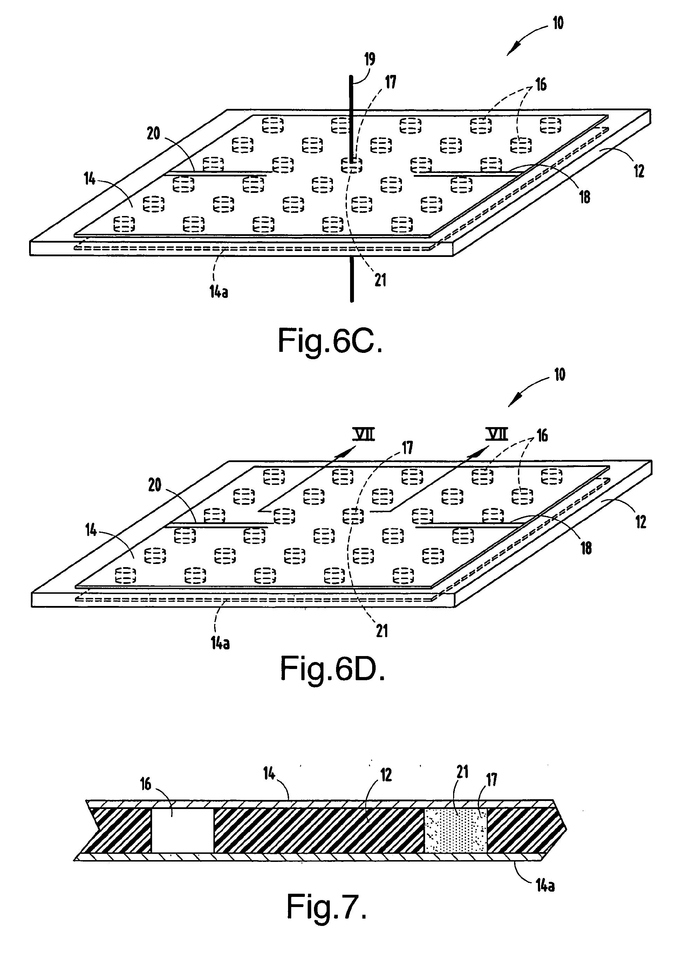

Fig. 6C illustrates a magnetic field 19 being applied near the via hole containing the magnetically alignable conductive material 17, in a third step of the method, causing the magnetically alignable conductive particles in the magnetically alignable conductive material 17 to align at least partially into a conductive column or via 21. Next, heat is applied to the magnetically alignable conductive material 17 such that the conductive via 21 formed by the application of the magnetic field 19 to the magnetically alignable conductive material 17 will remain in place after the magnetic field 19 is removed. In the final step of this method, the magnetic field 19 is removed from the magnetically alignable conductive material 17.

The resulting EBG device 10 is illustrated in Figs. 6D-7 after the steps of the method have been completed. As can be seen, the EBG device 10 contains a regular pattern of via holes 16, interrupted by conductive via 21 formed by the application of a magnetic field 19 to magnetically alignable conductive material 17. The regular pattern of via holes 16 interrupted by the conductive via 21 formed by the application of a magnetic field 19 to magnetically alignable conductive material 17 are seen in Fig. 7. Because the regular pattern of via holes 16 is interrupted in at least one place (here, by a conductive via 21), the resulting structure is an EBG device 10 having a defect resonator that has been tuned by a magnetic field. It should be appreciated that although only one via hole 16 is shown being filled with magnetically alignable conductive material 17 to form a conductive via 21. More than one via hole 16 could be at least partially or substantially filled with magnetically alignable conductive material 17 to form multiple conductive vias 21, resulting in an EBG device 10 having multiple defect resonators.

In an alternate embodiment, all the via holes may be filled with magnetically alignable conductive matter, which is caused to align into conductive vias by a magnetic field. In this case, the resulting structure is an EBG device without a defect resonator.

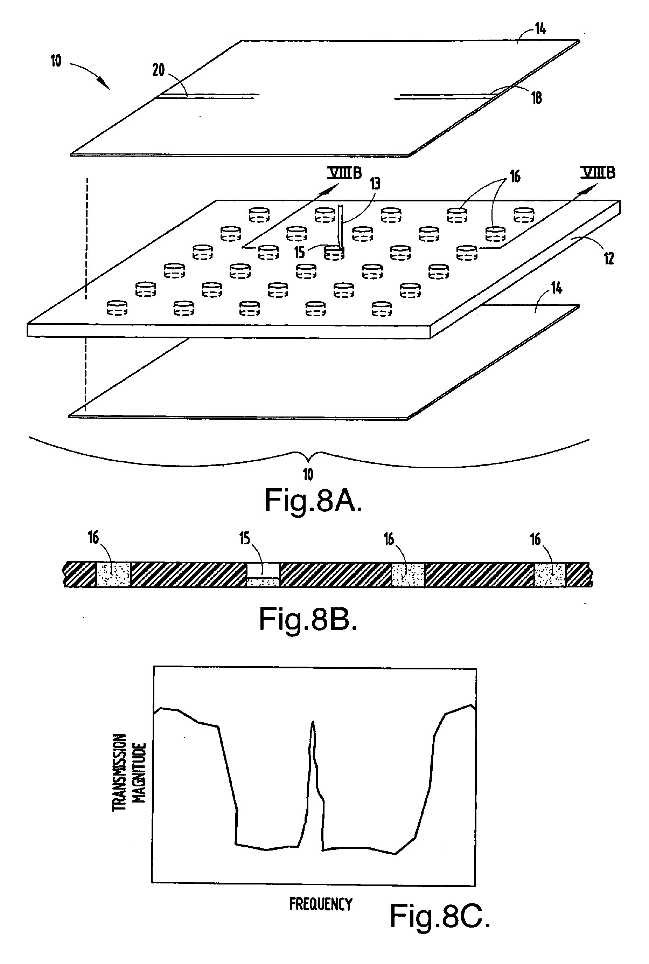

Referring to Figs. 8A-8B, a method for creating a defect via 13 in an EBG device 10 is generally illustrated, according to a third embodiment of the present invention. According to a first step of this method, an EBG device 10 is provided. The EBG device 10 includes a periodic lattice of vias 16. As shown, the vias 16 are approximately the same size and shape, and are made of a metal or metal alloy. In other embodiments, the vias may be made of other material, such as, for example, a dielectric material. The regular periodic lattice of vias 16 is shown uninterrupted by defects. The EBG device 10 is also shown having a coplanar waveguide, including a coplanar waveguide input 18 and a coplanar waveguide output 20. The EBG device 10 also includes ground planes 14 positioned on opposite sides of EBG device 10.

In a second step of the method, according to the third embodiment, the size, shape and/or height of at least one of the vias 16 is altered to create a defect via 15 in the periodic lattice of vias 16. As shown, defect via 15 is formed by using a laser 13 to impact the surface of the via 16 to remove via material. The removal of via material from via 16 has the effect of decreasing the height of the via 16. Because the height of the via 16 has been altered such that it is different from the height of the other vias 16, the via 16 now represents a defect via 15 in the regular pattern of vias in EBG device 10. The presence of the defect via 15 has the effect of causing the EBG device 10 to have at least one defect resonant frequency.

Fig. 8C generally illustrates the transmission characteristics of an EBG device of Fig. 8A having a defect via 15 introduced by present method. As can be seen, the bandgap of EBG device 10 has a defect resonant frequency f(h) resulting from the defect resonator (defect via 15) introduced by the present method. Although the method as described uses a laser 13 to create defect via 15, it should be appreciated that other means, such as a water jet, mill, or other means capable of altering a via 16, could be used to introduce a defect via 15 into EBG device 10. In addition, although only one defect via 15 was introduced, it should be appreciated that the method can be applied to introduce multiple defect vias into EBG device 10, resulting in an EBG device 10 having multiple defect resonant frequencies.

Finally, while the method, according to the third embodiment, is used to alter a via to create a defect via, it should be appreciated that the method can be applied to create defects in EBG devices having a regular pattern of structures other than vias. In that case, the method would be used to alter the size, shape, height, and/or location of one of the structures to create a defect structure, resulting in an EBG device with a resonant frequency.

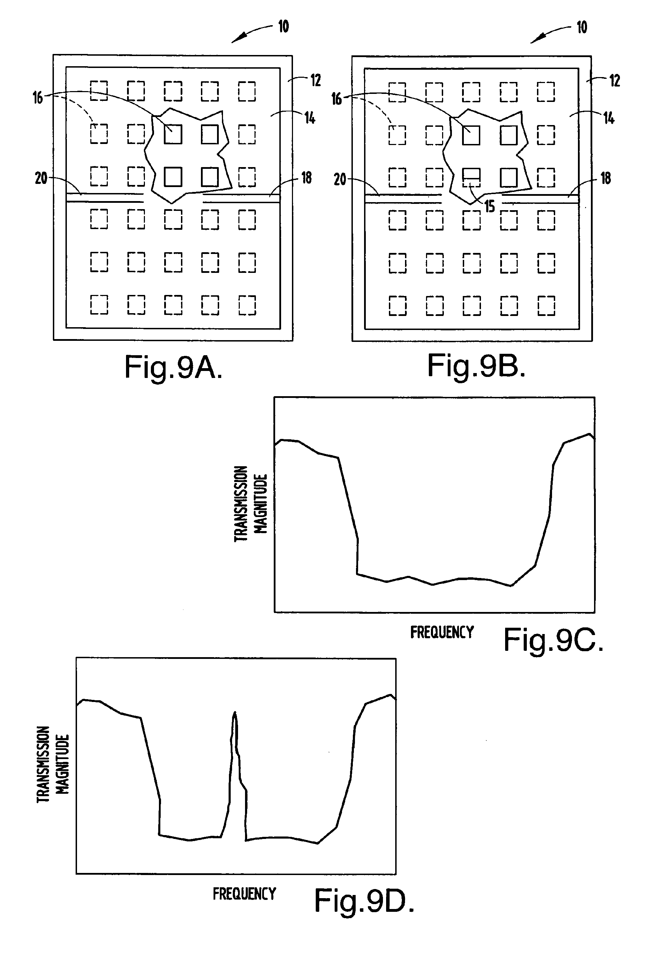

Referring to Figs. 9A-9D, an EBG device 10 and transmission characteristics thereof are shown, which are further useful in describing the method for creating a defect in an EBG device 10. In the first step of the method, an EBG device 10 having a coplanar waveguide input 18, coplanar waveguide output 20, planar substrate 12, ground plane 14 and a periodic lattice of conductive vias 16 is provided. Prior to introducing a defect, the EBG device 10 has transmission characteristics as shown in Fig. 9C. As can be seen, there are no resonant frequencies located within the bandgap associated with EBG device 10.

Referring to Fig. 9B, a defect 15 is created, as described above, in at least one of the vias 16 by means of a laser in a second step of the method. The laser is used to change at least one of the size, shape or location of at least one via 16.

Fig. 9D shows the transmission characteristics of an EBG device 10 after a defect 15 has been introduced by the method. As can be seen, the bandgap of the EBG device 10 now has at least one resonant frequency as a result of the defect 15 introduced by the method.

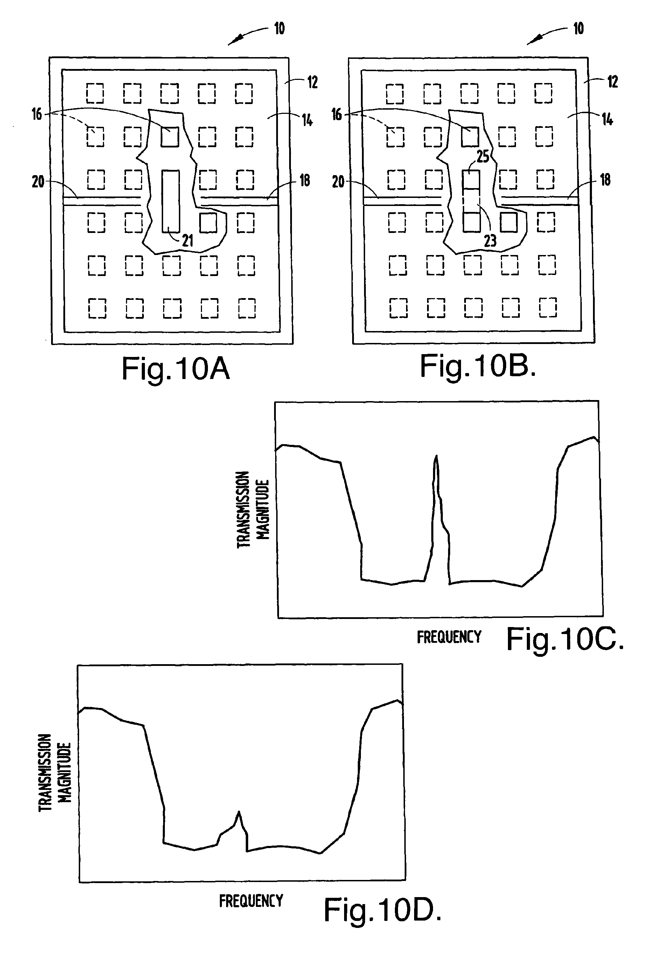

Referring to Figs. 10A-10D, a method for tuning a defect in an EBG device 10 to alter a resonant frequency is provided, according to a further embodiment of the present invention. In a first step of the method, an EBG device 10 is provided, as shown in Fig. 10A, having a planar substrate 12, ground plane 14, a periodic lattice of conductive vias 16, a coplanar waveguide input 18, a coplanar waveguide output 20 and at least one defect 21 in the periodic lattice of conductive vias 16. In another embodiment, the vias 16 are made of a material other than a conductive material, such as, for example, a dielectric material.

Referring to Fig. 10C, the transmission characteristics of the EBG device 10 having a resonant frequency are shown. The bandgap is interrupted in at least one place by a resonant frequency caused by the presence of a defect in the periodic lattice of vias 16 that is defect resonator 21. In a second step of the method, the defect 21 is altered by means of a laser to change at least one of the size, shape and location of the defect 21. As can be seen in Fig. 10B, defect 21 has been altered in step 2 such that it has the form of two conductive vias 25 that are positioned in what would be their proper locations in a defect-free periodic lattice of conductive vias 16. Conductive vias 25 are separated by an area 23 that has been altered by the laser. As shown, the resulting conductive vias 25 are of approximately the same size and shape of the other conductive vias 16. Because the structure of Fig. 10C after step 2 has a periodic lattice of vias 16 and 25 without a defect 21, the transmission characteristics of the EBG device 10 are similar to transmission characteristics of an EBG device lacking a defect resonator.

Fig. 10D generally illustrates a transmission characteristic of the EBG device 10 in which the defect resonator 21 has been removed by the method and replaced with conductive vias 25 located at proper positions in the periodic lattice of conductive vias 16. As can be seen, the transmission characteristics reflect that of a normal EBG device without a defect resonator (i.e., a bandgap filter without a resonant frequency within the bandgap). Any slight resonance remaining in the transmission characteristics after the defect 21 has been removed are due to the fact that it is difficult to precisely alter the characteristics of the defect 21 such that the resulting vias 25 exactly match the size and location required to eliminate resonance from the bandgap.

Although the method described in Figs. 10A-10D provides for a removal of the defect 21 by means of a laser, it should be appreciated that other means may be used to remove the defect, such as a water jet, mill, or other means capable of altering a via 16. In addition, although the method described in Figs. 10A-10D describes the removal of one defect 21, it should be appreciated that the method may be used to remove multiple defects 21 from an EBG device 10 having multiple defects (defect resonators) 21.

The present invention results in a magnetically tuned EBG device 30 generally illustrated in Fig. 4, according to one embodiment of the present invention. EBG device 30 includes first and second planar substrates 32 and 32a, ground planes 34 and 34a located on the inner surface of each of the first and second planar substrates 32 and 32a, respectively, a patterned mask 38 located on the outside surface of one of the first or second planar substrates 32 and 32a, and magnetically alignable conductive material 36 located between the inner surfaces of planar substrates 32 and 32a. At least some of the magnetically alignable conductive material 36 has been formed into conductive vias 46 and 47 by means of an applied magnetic field that has passed through magnetically permeable mask openings 40 located in patterned mask 38. Patterned mask 38 is also shown having a mask opening defect 42 for limiting the amount of magnetic field that can pass through patterned mask 38 in the vicinity of mask opening defect 42.

As can be seen in Fig. 5, magnetically alignable conductive material 36 has been magnetically aligned into a periodic lattice of conductive vias 46 and 47. Magnetically tuned EBG device 30 is also shown having a defect area 48 located beneath mask opening defect 42. Defect area 48 is an area in an otherwise periodic lattice of conductive vias where little or no magnetically aligned conductive material has been aligned into a conductive via. In another embodiment, EBG device 30 has multiple mask opening defects 42, and multiple defect areas 48 located below mask opening defects 42. Although Figs. 4 and 5 include both conductive columns 46 and 47 and defect area 48, it should be appreciated that a magnetically tuned EBG device 30 can be formed without a defect area 48. It should also be appreciated that patterned mask 38 can be a permanent part of EBG device 30 or can be used temporarily to form the conductive vias 46 and 47 and defect areas 48, and then removed.

The present invention also results in a magnetically tuned EBG device 10 generally illustrated in Fig. 6D, according to another embodiment of the present invention. The magnetically tuned EBG device 10 is shown having a planar substrate 12 with a periodic lattice of via holes 16. At least one of the via holes 16 is filled with a magnetically alignable conductive material 17 that has been aligned into a permanent conductive via 21. EBG device 10 is also shown having ground planes 14 and 14a located on the upper and lower surfaces of EBG device 10. As shown, permanent conductive via 21 represents a defect in the otherwise periodic lattice of vias, causing EBG device 10 to have a resonant frequency.

Returning to Fig. 7, a cross-section through the EBG device 10 of Fig. 6D is shown. Fig. 7 generally illustrates a planar substrate 12, ground planes 14 and 14a, a periodic lattice of via holes 16 and at least one via hole filled with magnetically alignable conductive material 17 that has been aligned into a permanent conductive via 21. It should be appreciated that via holes 16 not filled with magnetically alignable conductive material 17 could be filled with a material other than magnetically alignable conductive material 17, or could be left empty. It should also be appreciated that magnetically tuned EBG device 10 could include more than one via hole 16 filled with magnetically alignable conductive material 17 and aligned into permanent conductive vias 21.

Although the steps of the method, according to various embodiments of the present invention, were described in a certain order, it should be appreciated that the order of the steps can be changed without departing from the method. It should also be appreciated that additional planar substrates, ground planes, and patterned masks could be employed in the method.

The invention advantageously provides for Electromagnetic Bandgap (EBG) devices with pass bands that are tunable. The invention also provides for EBG devices with a defect resonator in which both the pass band and defect resonant frequency are tunable. Finally, the invention advantageously provides convenient methods for tuning EBG devices with and without defect resonators, for removing defect resonators from EBG devices having defect resonators, and for adding defect resonators to EBG devices.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method for making a magnetically tuned Electromagnetic Bandgap (EBG) device (30), comprising the steps of:
providing first (32) and second (32a) substantially parallel planar substrates comprising dielectric material, wherein said first (32) and second (32a) substantially parallel planar substrates substantially overlap;
placing magnetically alignable conductive material (36) between and adjacent to the overlapping portion of said first (32) and second (32a) substantially parallel planar substrates; and
applying a magnetic field (44, 45) in the vicinity of said magnetically alignable conductive material (36), causing at least some of said magnetically alignable conductive material (36) to align into conductive vias (46, 47) to thereby form a magnetically tuned EBG device (30).

2. The method of claim 1, further comprising the step of:
placing a ground plane (34, 34a) between each of said first and second substantially parallel planar substrates (32, 32a) and the magnetically alignable conductive material (36).

3. The method of claim 1, further comprising the step of locating a patterned mask (38) substantially parallel and adjacent to the overlapping portion of at least one of said first and second planar substrates (32, 32a), said mask (38) having magnetically permeable openings (40) defining a periodic lattice, and wherein portions of said mask that are not openings are less permeable to a magnetic field than the openings (40).

4. The method of claim 3, further comprising the step of applying a magnetic field (44, 45) in the vicinity of said magnetically alignable conductive material (36) such that at least some of the magnetic field (44, 45) passes through the magnetically permeable openings (40) of said patterned mask (38), causing at least some of said magnetically alignable conductive material (36) to align into conductive vias (46, 47) in a pattern that essentially corresponds to the locations of the openings (40) in said mask (38).

5. The method of claim 4, further comprising the step of curing said magnetically alignable conductive material (36) such that at least some of said electromagnetically conductive material (36) remains partially aligned in conductive vias (46, 47) after the magnetic field (44, 45) is removed.

6. The method of claim 5, wherein the curing step comprises heating the magnetically alignable conductive material (36).

7. The method of claim 1, wherein the magnetically alignable conductive material (36) comprises an epoxy.

8. The method of claim 1, wherein at least one of said first and second planar substrates (32, 32a) comprises a waveguide.

9. The method of claim 4, wherein the periodic lattice of openings (40) of the mask (38) is interrupted in at least one place by a mask opening defect (42) having a different magnetic permeability than that of the magnetically permeable openings (40) of the mask (38).

10. The method of claim 9, wherein less magnetic energy passes (44, 45) through the at least one mask opening defect (42) than passes through the magnetically permeable openings (40) of the mask (38), resulting in at least one structural defect (48) that is an area within the magnetically alignable conductive material (36) adjacent to said mask defect (42) having a conductivity different than that of the conductive vias (46, 47) corresponding to the locations of the magnetically permeable mask openings (40).

11. The method of claim 10, further comprising the step of curing said magnetically alignable conductive material (36) such that at least some of said electromagnetically conductive material (36) remains partially aligned in conductive vias (46, 47) after the magnetic field (44, 45) is removed, and such that that at least one structural defect (48) remains in the device (30), resulting in an EBG structure (30) containing a defect resonator (48) and having an EBG bandgap frequency and defect resonator frequency.

12. The method of claim 1, further comprising the step of varying the magnetic field (44, 45) across the device (30), resulting in conductive vias (46, 47) with varying levels of conductivity proportional to a strength of the magnetic field (44, 45) entering the magnetically alignable conductive material (36) near each conductive via (46, 47).

13. The method of claim 11, further comprising the step of varying the magnetic field (44, 45) across the device (30), resulting in conductive vias (46, 47) with varying levels of conductivity proportional to a strength of the magnetic field (44, 45) entering the magnetically alignable conductive material (36) near each conductive via (46, 47).

14. The method of claim 13, wherein at least one of the EBG bandgap frequency and defect resonator frequency is altered by varying at least one of the strength and uniformity of the applied magnetic field (44, 45).

15. A method for making a magnetically tuned Electromagnetic Bandgap (EBG) device (10) having at least one defect resonator, comprising the steps of:
providing a substantially planar structure (12) having a first thickness, a first outer surface orthogonal to said first thickness and having a length and width greater than said first thickness, a second outer surface opposite said first outer surface and orthogonal to said first thickness, said second outer surface having a length and width greater than said first thickness, and a periodic lattice of via holes (16) disposed between said first outer surface and said second outer surface;
disposing magnetically alignable conductive material (17) in at least one of said via holes (16); and
applying a magnetic field (19) in the vicinity of said magnetically alignable conductive material (17), causing at least some of said magnetically alignable conductive material (17) to align into a conductive via (21)within said at least one via hole (16) to form a magnetically tuned EBG device (10).

16. The method of claim 15, further comprising the step of disposing in at least one other via hole (16) a material different from said magnetically alignable material (17).

17. The method of claim 15, further comprising the step of curing the magnetically alignable conductive material (17) such that the magnetically alignable conductive material (17) remains aligned in a permanent conductive via (21) after the magnetic field (19) is removed.

18. The method of claim 17, wherein the curing step comprises heating the magnetically alignable conductive material (17).

19. The method of claim 15, wherein the magnetically alignable conductive material (17) comprises an epoxy.

20. The method of claim 15, wherein the conductivity of the conductive via (21) increases as the magnitude of the applied magnetic field increases (19).

21. The method of claim 15, wherein the conductive via (21) functions as a defect resonator.

22. The method of claim 15, wherein the resulting device (10) comprises a waveguide (18, 20).

23. A magnetically tuned Electromagnetic Bandgap (EBG) device (30), comprising:
first and second substantially parallel planar substrates comprising dielectric material (32, 32a), wherein said first and second substantially parallel planar substrates (32, 32a) substantially overlap; and
magnetically alignable conductive material (36) located between and adjacent to the overlapping portion of said first and second planar substrates (32, 32a), wherein at least some of the magnetically alignable conductive material (36) has been magnetically aligned into a permanent periodic lattice of conductive vias (46, 47).

24. The device (30) of claim 23, wherein the magnetically alignable conductive material (36) comprises an epoxy.

25. The device (30) of claim 23, wherein a mask (38) having a periodic lattice of magnetically permeable openings (40) is located adjacent and parallel to at least one of said first and second planar substrates (32, 32a).

26. The device (30) of claim 25, wherein the periodic lattice of magnetically permeable openings (40) is interrupted by at least one defect (42).

27. The device (30) of claim 23, wherein the periodic lattice of conductive vias (46, 47) contains at least one defect via (48) having a conductivity that differs from the conductivity of the other conductive vias (46, 47), resulting in the device (30) having at least one defect resonant frequency.

28. The device (30) of claim 27, wherein the defect resonant frequency varies based on at least one of the size, number and location of the at least one defect via (48).

29. The device (30) of claim 23, wherein the conductivity of the periodic lattice of conductive vias (46, 47) varies systematically within the device (30).

30. A magnetically tuned Electromagnetic Bandgap (EBG) device (10), comprising:
an Electromagnetic Bandgap (EBG) device (10) having a periodic lattice of via holes (16); and
magnetically alignable conductive material (17) disposed in at least one via hole (16), wherein at least some of the magnetically alignable conductive matter (17) has been magnetically aligned into a permanent conductive via (21).

31. The device (10) of claim 30, wherein at least one of said via holes (16) has a material that is not magnetically alignable disposed therein.

32. The device (10) of claim 30, wherein the magnetically alignable conductive material (17) comprises an epoxy.

33. The device (10) of claim 30, wherein the conductivity of the at least one via hole (16) containing magnetically alignable conductive material (17) is different than that of the via holes (16) not containing said magnetically alignable conductive material (17).

34. A method for creating a defect in an Electromagnetic Bandgap (EBG) device (10), comprising the steps of:
providing an Electromagnetic Bandgap device (10) comprising a periodic lattice of vias (16), wherein said vias (16) have essentially the same size and shape; and
altering at least one of the size, shape and height of at least one of said vias (16) to create a defect (15) in the periodic lattice of vias (16).

35. The method of claim 34, wherein the step of altering the at least one via (16) to create a defect (15) comprises one of a laser, a water jet, and a mill operation.

36. The method of claim 34, wherein the alteration of the device (10) results in the EBG device (10) having at least one defect resonant frequency.

37. A method for tuning a defect in an Electromagnetic Bandgap (EBG) device (10) to alter a resonant frequency of the EBG device (10), comprising the steps of:
providing an Electromagnetic Bandgap device (10) comprising a periodic lattice of vias (16) of essentially the same size and shape, and wherein said periodic lattice of vias (16) comprises at least one defect via (21) having a size, shape or depth that is different from that of the other periodic vias (16); and
altering at least one of the size, shape and depth of said at least one defect via (21).

38. The method of claim 37, wherein the step of altering the at least one defect via (21) comprises one of a laser, a water jet, and a mill operation.

39. The method of claim 37, wherein the alteration of the defect via (21) results in the Electromagnetic Bandgap device (10) having a different resonant frequency than prior to the alteration.

40. The method of claim 37, wherein the alteration of the defect via (21) decreases the magnitude of the resonant frequency of the Electromagnetic Bandgap device (10) to a level lower than the magnitude of the resonant frequency prior to the alteration of the defect via (21).
